# FASCICULE DE BREVET EUROPEEN

(11) **EP 3 073 541 B1**
(45) Date de publication et mention de la délivrance du brevet: **07.03.2018**
(21) Numéro de dépôt: 16161560.4
(22) Date de dépôt: 22.03.2016
(51) Int. Cl.: H01L 41/45, H01L 41/193

(54) **DISPOSITIF PIÉZOÉLECTRIQUE**
PIEZOELEKTRISCHE VORRICHTUNG
PIEZOELECTRIC DEVICE

(30) Priorité: 24.03.2015 FR 1552434
(43) Date de publication de la demande: 28.09.2016
(73) Titulaire: COMMISSARIAT À L'ÉNERGIE ATOMIQUE ET AUX ÉNERGIES ALTERNATIVES, 75015 Paris (FR)
(72) Inventeur: ALIANE, Abdelkader, 38100 GRENOBLE (FR); BENWADIH, Mohammed, 94500 CHAMPIGNY-SUR-MARNE (FR)
(74) Mandataire: Thibon, Laurent

(56) Documents cités:
- WO-A1-2014/001272
- US-A1- 2012 161 587
- ZHIJIANG CAI ET AL: "Characteristics and performance of electroactive paper actuator made with cellulose/polyurethane semi-interpenetrating polymer networks", JOURNAL OF APPLIED POLYMER SCIENCE, vol. 109, no. 6, 15 septembre 2008 (2008-09-15), pages 3689-3695, XP055249683, US ISSN: 0021-8995, DOI: 10.1002/app.28572
- SURESHA K MAHADEVA ET AL: "Electrical and Electromechanical Properties of Cellulose-Polypyrrole-Ionic Liquid Nanocomposite: Effect of Polymerization Time", IEEE TRANSACTIONS ON NANOTECHNOLOGY, IEEE SERVICE CENTER, PISCATAWAY, NJ, US, vol. 10, no. 3, 1 mai 2011 (2011-05-01), pages 445-450, XP011322054, ISSN: 1536-125X, DOI: 10.1109/TNANO.2010.2046644
- AMALRAJ JOHN ET AL: "The preparation, characterization and actuation behavior of polyaniline and cellulose blended electro-active paper", SMART MATERIALS AND STRUCTURES, IOP PUBLISHING LTD., BRISTOL, GB, vol. 19, no. 4, 1 avril 2010 (2010-04-01), page 45011, XP020175651, ISSN: 0964-1726
- ZHIJIANG CAI ET AL: "Characteristics and bending performance of electroactive polymer blend made with cellulose and poly(3-hydroxybutyrate)", CARBOHYDRATE POLYMERS, APPLIED SCIENCE PUBLISHERS, LTD. BARKING, GB, vol. 87, no. 1, 16 août 2011 (2011-08-16), pages 650-657, XP028316815, ISSN: 0144-8617, DOI: 10.1016/J.CARBPOL.2011.08.038 [extrait le 2011-08-22]

## Description

### Domaine

La présente demande concerne un dispositif piézoélectrique à base de matériaux organiques et un procédé de fabrication d'un tel dispositif.

### Exposé de l'art antérieur

Le brevet US 8 680 741 décrit un capteur comprenant un film de papier ayant des propriétés piézoélectriques. Des électrodes, disposées sur les faces du papier, permettent d'appliquer une tension au film de papier.

Un inconvénient du capteur décrit dans ce brevet est que le film de papier utilisé doit être du type comprenant des fibres de cellulose orientées sensiblement selon une direction privilégiée et que les électrodes doivent être orientées à 45° des fibres de cellulose pour obtenir un effet piézoélectrique maximal. L'article "Charaacteristics and performance of electroactive paper actuator made with cellulose/ polyurethane semi-interpenetrating polymer networks" (Zhijiang Cai et al. J. Appl. Polymer Sci. 109 (2008)3689-3695) décrit divulgue un film de papier comprenant des fibres de cellulose et contenant comme additif la hexaméthylène diisocyanate, greffé aux fibres de cellulose. Il serait souhaitable de pouvoir réaliser un dispositif comprenant un film de papier dont les propriétés piézoélectriques sont indépendantes de l'orientation des électrodes par rapport aux fibres de cellulose du film de papier. En outre, il serait souhaitable de pouvoir réaliser un film de papier ayant des propriétés piézoélectriques et dont les fibres de cellulose n'ont pas d'orientation privilégiée, notamment un film de papier comprenant des plaquettes de cellulose.

### Résumé

Un objet d'un mode de réalisation est de pallier tout ou partie des inconvénients des dispositifs piézoélectriques décrits précédemment comprenant un film de papier ayant des propriétés piézoélectriques.

Un autre objet d'un mode de réalisation est que le dispositif piézoélectrique peut être fabriqué à bas coût.

Un autre objet d'un mode de réalisation est que le dispositif piézoélectrique peut être réalisé, au moins en partie, par des techniques d'impression.

Ainsi, un mode de réalisation prévoit un dispositif piézoélectrique comprenant :
un film de papier comprenant des fibres de cellulose et contenant un additif choisi parmi le groupe comprenant le 4-fluorophénéthyl isocyanate, le 2-2 diphényléthyl isocyanate, le nitrophényl isocyanate, le 1-adamantyl isocyanate, le cyanophényl isocyanate et le triphénylamine greffé aux fibres de cellulose, le film ayant, en outre, une première face, et une deuxième face opposée à la première face ; et
une première électrode disposée sur la première face et une deuxième électrode disposée sur la deuxième face.

Selon un mode de réalisation, le dispositif comprend, en outre :
une couche piézoélectrique s'étendant sur la première électrode ; et
une troisième électrode, la couche piézoélectrique étant interposée entre la première électrode et la troisième électrode.

Selon un mode de réalisation, la couche piézoélectrique comprend du polyfluorure de vinylidène et/ou au moins un copolymère du polyfluorure de vinylidène, notamment un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

Selon un mode de réalisation, le dispositif comprend, en outre, un premier revêtement entre la première face et la première électrode et un deuxième revêtement entre la deuxième face et la deuxième électrode.

Selon un mode de réalisation, le premier revêtement et/ou le deuxième revêtement comprennent un matériau choisi parmi le groupe comprenant le 3-aminopropyl triméthyloxysilane, les polyimides et le poly(N-isopropylacrylamide).

Selon un mode de réalisation, la première électrode et/ou la deuxième électrode comprennent des ouvertures traversantes.

Un autre mode de réalisation prévoit un procédé de fabrication d'un dispositif piézoélectrique comprenant les étapes suivantes :
a) prévoir un film de papier comprenant des fibres de cellulose et ayant une première face et une deuxième face, opposée à la première face ;
b) tremper le film de papier dans une solution comportant au moins un additif choisi parmi le groupe comprenant le 4-fluorophénéthyl isocyanate, le 2-2 diphényléthyl isocyanate, le nitrophényl isocyanate, le 1-adamantyl isocyanate, le cyanophényl isocyanate et le triphénylamine ;
c) greffer l'additif aux fibres de cellulose ; et
d) former une première électrode sur la première face et une deuxième électrode sur la deuxième face.

Selon un mode de réalisation, l'étape c) comprend l'exposition du film de papier à des impulsions d'un rayonnement ultraviolet.

Selon un mode de réalisation, les impulsions ont une durée comprise entre 0,5 et 2 ms et une fluence en énergie comprise entre 5 et 20 J/cm².

Selon un mode de réalisation, le procédé comprend, en outre, les étapes suivantes :
e) former une couche comprenant un solvant et du polyfluorure de vinylidène et/ou au moins un copolymère du polyfluorure de vinylidène, notamment un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères ;
f) exposer la couche à des impulsions d'un rayonnement ultraviolet.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un mode de réalisation d'un dispositif piézoélectrique ;
la figure 2 est une vue de dessus, partielle et schématique, d'un autre mode de réalisation d'un dispositif piézoélectrique ;
la figure 3 représente une courbe d'évolution de la déformation du dispositif piézoélectrique de la figure 1 en fonction de la tension appliquée au dispositif ;
les figures 4 et 5 sont des vues en coupe, partielles et schématiques, d'autres modes de réalisation d'un dispositif piézoélectrique ;
les figures 6A à 6C sont des vues en coupe, partielles et schématiques, des structures obtenues à des étapes successives d'un mode de réalisation d'un procédé de fabrication du dispositif piézoélectrique représenté en figure 1 ; et
les figures 7A à 7D sont des vues en coupe, partielles et schématiques, des structures obtenues à des étapes successives d'un mode de réalisation d'un procédé de fabrication du dispositif piézoélectrique représenté sur la figure 3 ou 4.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés. En particulier, les dispositifs de commande des dispositifs piézoélectriques sont bien connus de l'homme du métier et ne sont pas décrits en détail. Sauf précision contraire, les expressions "approximativement", "sensiblement", et "de l'ordre de" signifient à 10 % près, de préférence à 5 % près. Dans la suite de la description, l'expression élément "à base de polyfluorure de vinylidène (PVDF)" signifie un copolymère comprenant au moins 70 % en masse molaire du monomère fluorure de vinylidène (VDF) et éventuellement d'au moins un autre monomère comme par exemple le trifluoroéthylène (TrFE) ou le tétrafluoroéthylène (TFE).

Des modes de réalisation d'un dispositif piézoélectrique adaptés à la réalisation d'un haut-parleur vont être décrits. Toutefois, il est clair que le dispositif piézoélectrique peut être utilisé pour d'autres applications, par exemple pour la réalisation d'un capteur, notamment un capteur de pression, ou d'un dispositif de récupération d'énergie.

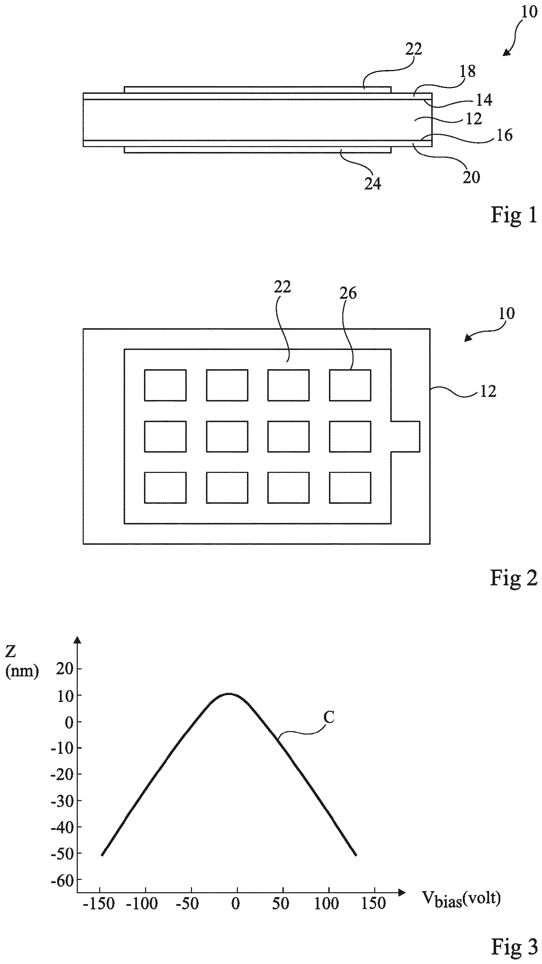

La figure 1 représente un mode de réalisation d'un dispositif piézoélectrique 10. Le dispositif piézoélectrique 10 comprend un film de papier 12 ayant deux faces 14, 16 opposées. Un revêtement 18 recouvre la face 14 et est au contact de la face 14, et un revêtement 20 recouvre la face 16 et est au contact de la face 16. Une première électrode 22 recouvre le revêtement 18 et est au contact du revêtement 18, et une deuxième électrode 24 recouvre le revêtement 20 et est au contact du revêtement 20. Au moins une partie de l'électrode 22 est en regard d'au moins une partie de l'électrode 24. Dans le mode de réalisation représenté, toute la surface de l'électrode 22 en contact avec le revêtement 18 est en regard de la surface de l'électrode 24 en contact avec le revêtement 20.

L'épaisseur du film de papier 12 peut être comprise entre 50 et 300 µm, par exemple égale à 200 µm. Le film de papier 12 peut être un film souple présentant un comportement flexible, c'est-à-dire qu'il peut sous l'action d'une force extérieure, se déformer, notamment se plier, sans se casser ou se déchirer. Le film de papier 12 est, par exemple, un film de papier commercialisé sous l'appellation PowerCoat par la société Arjowiggins.

Le film de papier 12 comprend au moins 40 % en poids, de préférence plus de 50 % en poids, plus préférentiellement plus de 60 % en poids de fibres de cellulose. Les fibres de cellulose du film de papier 12 peuvent avoir une orientation privilégiée. A titre de variante, les fibres de cellulose peuvent être assemblées en plaquettes de fibres de cellulose. Le terme "plaquette" désigne une structure tridimensionnelle incluse dans un parallélogramme rectangle dont deux côtés, appelés dimensions majeures, sont compris entre 5 nm et 2,5 µm, de préférence entre 50 nm et 2,5 µm, et sont supérieurs à 5 fois, de préférence supérieurs à 10 fois, le troisième côté, appelé dimension mineure, qui peut être compris entre 100 nm et 1 µm. Les orientations des fibres de cellulose peuvent être différentes d'une plaquette à l'autre.

Le film de papier 12 comprend, en outre, des additifs greffés aux fibres de cellulose. L'additif est choisi parmi le groupe comprenant le 4-fluorophénéthyl isocyanate, le 2-2 diphényléthyl isocyanate, le nitrophényl isocyanate, le 1-adamantyl isocyanate, le cyanophényl isocyanate et le triphénylamine. Le film de papier 12 peut comprendre entre 0,1 et 10 % en poids de l'additif.

Chaque revêtement 18, 20 favorise notamment l'accroche des électrodes 22, 24 au film de papier 12. Chaque revêtement 18, 20 peut correspondre à une couche ayant une épaisseur comprise entre 100 nm et 300 nm, notamment environ 200 nm. Les inventeurs ont mis en évidence que l'effet piézoélectrique est augmenté lorsque l'absorption d'humidité par le film de papier 12 est augmentée. Dans ce but, selon un mode de réalisation, chaque revêtement 18, 20 peut être en un matériau ayant une forte affinité avec l'eau, par exemple un matériau choisi parmi le groupe comprenant le 3-aminopropyl triméthyloxysilane, les polyimides ou le poly(N-isopropylacrylamide) (polyNIPAM).

Chaque électrode 22, 24 peut être en oxyde d'étain et d'indium, en un matériau métallique, notamment l'argent, l'or, le nickel, le palladium, le platine, l'aluminium, le cuivre, le titane ou un alliage ou un mélange d'au moins deux de ces matériaux, en un polymère conducteur, par exemple le poly(3, 4-éthylènedioxythiophène) : poly(styrène sulfonate) (PEDOT : PSS) ou en graphène. L'épaisseur de chaque électrode 22, 24 peut être comprise entre 10 et 300 nm, par exemple environ 100 nm.

Les inventeurs ont mis en évidence que l'effet piézoélectrique est augmenté lorsque l'absorption d'humidité par le film de papier 12 est augmentée. Dans ce but, selon un mode de réalisation, chaque électrode 22, 24 peut être recouverte d'une couche, non représentée sur la figure 1, d'un matériau ayant une forte affinité avec l'eau, de préférence un matériau polaire, par exemple un matériau choisi parmi le groupe comprenant le 2,2'-(éthylènedioxy) diéthanéthiol, le héxa(éthylène glycol) dithiol, le tétra(éthylène glycol) dithiol, le (11-mercaptoundécyl) tétra (éthylène glycol), le (11-mercaptoundécyl) héxa (éthylène glycol) et le triéthylène glycol mono-11-mercaptoundécyl éther.

Selon un mode de réalisation, le matériau composant chaque électrode 22, 24 est un matériau poreux. Ceci permet d'augmenter la surface d'échange entre le film de papier 12 et l'atmosphère au travers des électrodes 22, 24 pour augmenter l'absorption d'eau par le film de papier 12.

La figure 2 est une vue de dessus d'un mode de réalisation du dispositif piézoélectrique 10 dans lequel l'électrode 22, 24 comprend des ouvertures traversantes 26 pour augmenter la surface d'échange entre le film de papier 12 et l'atmosphère pour augmenter l'absorption d'eau par le film de papier 12. Chaque ouverture traversante 26 peut avoir, en vue de dessus, une forme rectangulaire, dont le grand côté peut être compris entre 1 µm et 100 µm.

Selon un autre mode de réalisation, chaque ouverture 26 peut contenir un matériau hydrophile et/ou poreux qui favorise l'absorption d'humidité. Selon un mode de réalisation, chaque électrode 22, 24 est en graphène et les ouvertures 26 peuvent contenir de l'oxyde de graphène.

La figure 3 représente une courbe C d'évolution du déplacement z maximal du film de papier 12 en fonction de la tension V_{bias} appliquée entre les électrodes 22 et 24. La courbe C met en évidence les propriétés piézoélectriques du film de papier 12. La courbe C a été obtenue avec un dispositif piézoélectrique 10 ayant les caractéristiques suivantes :
film de papier 12 commercialisé sous l'appellation PowerCoat par la société Arjowiggins ayant une épaisseur de 200 µm contenant du 4-fluorophénéthyl isocyanate ;
revêtement 18, 20 en polyimide ; et
électrodes 22, 24 en argent ayant une épaisseur de 8 µm.

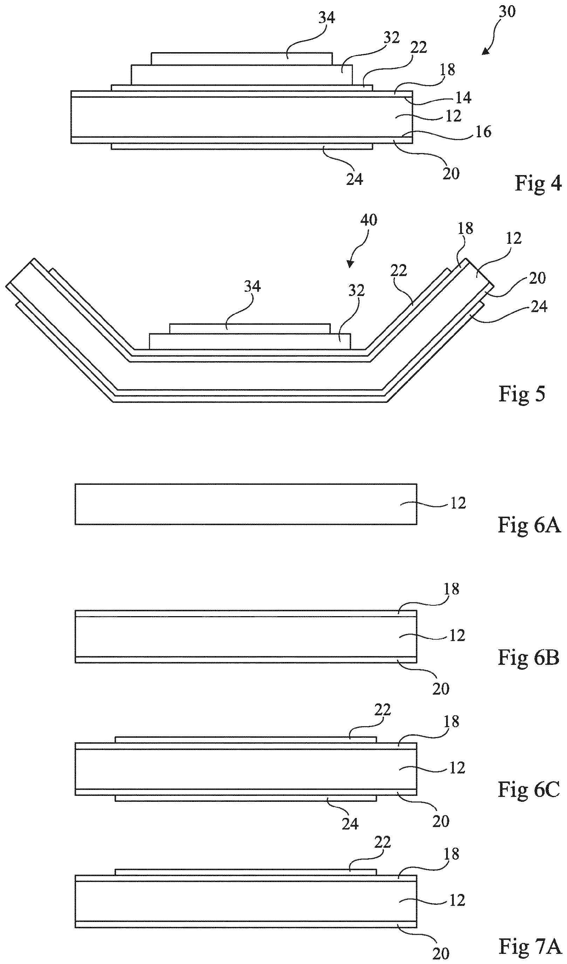

La figure 4 est une vue en coupe d'un autre mode de réalisation d'un dispositif piézoélectrique 30. Le dispositif piézoélectrique 30 comprend la totalité des éléments du dispositif piézoélectrique 10 représenté en figure 1 et comprend, en outre, une couche piézoélectrique 32 reposant sur l'électrode 22 et au contact de l'électrode 22 et une troisième électrode 34 reposant sur la couche piézoélectrique 32, du côté de la couche piézoélectrique 32 opposé à l'électrode 22, et au contact de la couche piézoélectrique 32.

La couche piézoélectrique 32 peut être réalisée en un composé à base de PVDF. Le composé à base de PVDF peut comprendre le seul polymère PVDF, un seul copolymère du PVDF, un mélange de deux ou plus de deux copolymères du PVDF, un mélange du polymère PVDF et d'au moins un copolymère du PVDF. De préférence, le copolymère du PVDF est le poly(fluorure de vinylidène - tri fluoro éthylène) (P(VDF-TrFE)), notamment le P(VDFₓ-TrFE₁₀₀₋ₓ) où x est un nombre réel compris entre 60 et 80, notamment environ 70, le poly(fluorure de vinylidène - tétrafluoroéthylène), le poly((fluorure de vinylidène - trifluoroéthylène - chlorofluoroéthylène) (P(VDF-TrFE-CFE) ou le poly((fluorure de vinylidène - trifluoroéthylène - chlorotrifluoro éthylène) (P(VDF-TrFE-CTFE). De préférence, la couche piézoélectrique 32 est en P(VDF-TrFE). Selon un mode de réalisation, la couche piézoélectrique 32 comprend plus de 25 % en mole de PVDF ou du copolymère de PVDF. La masse molaire du polymère de PVDF ou du copolymère de PVDF est supérieure ou égale à 415000 g/mol.

Le composé à base de PVDF peut, en outre, comprendre des charges. Les charges peuvent correspondre à des particules céramiques, par exemple des particules de titanate de baryum (BaPiO₃), des particules de zirconate titanate de plomb (PbZrTiO₃ ou PZT), des particules de titanate de plomb (PbTiO₃) ou des particules de tantalate de lithium (LiTaO₃). La concentration en poids de charges dans le composé à base de PVDF peut varier de 5 % à 25 %.

Le composé peut donc comprendre un mélange du polymère PVDF et d'au moins une céramique ou un mélange d'au moins un copolymère du PVDF et d'au moins une céramique, par exemple les mélanges suivants : PVDF/BaTiO₃, P(VDF-TrFE)/BaTiO₃, P(VDF-TrFE-CTFE)/BaTiO₃, P(VDF-TrFE-CFE)/BaTiO₃, PVDF/PbZrTiO₃, P(VDF-TrFE)/PbZrTiO₃, P(VDF-TrFE-CTFE)/PbZrTiO₃, P(VDF-TrFE-CFE)/PbZrTiO₃, PVDF/PbTiO₃, P(VDF-TrFE)/PbTiO₃, P(VDF-TrFE-CTFE)/PbTiO₃, P(VDF-TrFE-CFE)/PbTiO₃, PVDF/LiTaO₃, P(VDF-TrFE)/LiTaO₃, P(VDF-TrFE-CTFE)/LiTaO₃, P(VDF-TrFE-CFE)/LiTaO₃.

L'électrode 34 peut être réalisée avec le même matériau que l'électrode 24. L'électrode 22 peut être en un matériau différent du matériau des électrodes 24 et 34.

De préférence, l'électrode 22 du dispositif piézoélectrique 30 est au moins en partie en un matériau carboné conducteur électriquement. Un matériau carboné est un matériau comprenant plus de 80 %, de préférence plus de 90 %, en poids de carbone. Le matériau carboné peut correspondre au produit obtenu après le séchage d'une encre carbone ou peut correspondre à du graphène conducteur ou à un mélange entre du noir de carbone et une encre argent. L'encre carbone peut être l'encre carbone commercialisée par la société Creative Materials sous l'appellation 112-48. De préférence, l'électrode 22 est au moins en partie en graphène. De préférence, le matériau carboné a un module d'Young inférieur à 10 GPa.

Selon un mode de réalisation, l'électrode 34 comprend des nanofils ou nanotubes d'argent. Chaque nanofil ou nanotube d'argent peut avoir une longueur comprise entre 1 µm et 10 µm, de préférence entre 4 µm et 5 µm. Le diamètre de chaque nanofil ou nanotube d'argent peut être compris entre 10 nm et 200 nm, de préférence entre 60 nm et 100 nm.

Selon un mode de réalisation, en fonctionnement, le film de papier piézoélectrique 12 et la couche piézoélectrique 32 peuvent être connectés en parallèle à une source de tension, c'est-à-dire que l'électrode 22 est reliée à une première borne de la source de tension et que les électrodes 24 et 34 sont reliées à une deuxième borne de la source de tension.

La figure 5 est une vue en coupe analogue à la figure 4 d'un autre mode de réalisation d'un dispositif piézoélectrique 40. Le dispositif piézoélectrique 40 comprend la totalité des éléments du dispositif piézoélectrique 30 représenté en figure 4. De plus, le film de papier 12 a été déformé pour adopter une forme tridimensionnelle. La forme du film de papier 12 peut être adaptée à l'utilisation prévue du dispositif piézoélectrique 40. A titre d'exemple, dans le cas où le dispositif piézoélectrique 40 est utilisé comme haut-parleur, le film de papier 12 peut être mis en forme pour jouer, en outre, le rôle d'une caisse de résonnance.

Selon un mode de réalisation, le film de papier 12 peut être mis sous la forme d'une monture d'une paire de lunettes, des haut-parleurs étant prévus sur les branches de la monture à proximité des oreilles.

Les figures 6A à 6C illustrent un mode de réalisation d'un procédé de fabrication du dispositif piézoélectrique représenté en figure 1.

La figure 6A représente la structure obtenue après avoir réalisé un traitement pour greffer aux fibres de cellulose du film de papier 12 au moins un additif choisi dans le groupe comprenant le 4-fluorophénéthyl isocyanate, le 2-2 diphényléthyl isocyanate, le nitrophényl isocyanate, le 1-adamantyl isocyanate, le cyanophényl isocyanate et le triphénylamine.

Selon un mode de réalisation, le traitement comprend les étapes successives suivantes :
tremper le film 12 dans une solution comprenant un solvant et l'additif de sorte que l'additif pénètre dans tout le volume du film de papier 12 ;
sécher le film 12, par exemple à l'air libre, pour évaporer le solvant ; et
greffer, ou fixer, l'additif aux fibres de cellulose du film 12, par exemple en exposant le film 12 à un rayonnement ultraviolet (UV), par une succession d'impulsions de rayonnement UV, ou flashs ultraviolets.

A titre d'exemple, le solvant est le toluène, l'acétone, l'isopropanol, le xylène ou le chloroforme. La solution peut comprendre de 5 % à 20 %, de préférence 15 %, en poids de l'additif. Le film est trempé par exemple entre 30 secondes et 5 minutes, notamment environ 1 minute, dans la solution. Par rayonnement UV, on entend un rayonnement dont les longueurs d'onde sont, au moins en partie, comprises entre 200 nm et 400 nm. Chaque impulsion UV a, par exemple, une durée comprise entre 0,5 et 2 ms, et une fluence en énergie comprise entre 5 et 30 J/cm², notamment environ 20 J/cm². Le nombre d'impulsions UV peut varier de 1 à 5 impulsions. La durée entre deux impulsions successives peut varier de 1 à 5 secondes. Les impulsions peuvent être émises à l'aide de l'équipement commercialisé sous l'appellation PulseForge par la société Novacentrix ou sous l'appellation Sinteron 2000 par la société Xenon Corporation. L'exposition du film de papier 12 aux impulsions UV permet d'obtenir un greffage de l'additif aux fibres de cellulose sans entraîner une évaporation trop importante de l'eau contenue dans le film de papier 12.

La figure 6B représente la structure obtenue après avoir formé les revêtements 18 et 20 sur les faces 14 et 16 du film de papier 12. Les revêtements 18, 20 peuvent être déposés par dépôt à la tournette, par impression par jet d'encre ou par pulvérisation. Le séchage du matériau déposé peut être réalisé par exposition à un rayonnement UV. Les impulsions UV ont, par exemple, une durée comprise entre 0,5 et 2 ms, et, par exemple, une fluence en énergie comprise entre 5 et 20 J/cm², notamment environ 15 J/cm². Le nombre d'impulsions UV peut varier de 1 à 15. La durée entre deux impulsions successives peut varier de 500 µs à 2 ms.

La figure 6C représente la structure obtenue après avoir formé les électrodes 22, 24 sur les revêtements 18, 20. Selon le matériau composant les électrodes 22, 24, le procédé de formation des électrodes 22, 24 peut correspondre à un procédé dit additif, par exemple par impression directe d'une composition fluide ou visqueuse comprenant le matériau composant les électrodes 22, 24 aux emplacements souhaités, par exemple par impression par jet d'encre, héliographie, sérigraphie, flexographie, revêtement par pulvérisation (en anglais spray coating) ou dépôt de gouttes (en anglais drop-casting). Selon le matériau composant les électrodes 22, 24, le procédé de formation des électrodes 22, 24 peut correspondre à un procédé dit soustractif, dans lequel le matériau composant les électrodes 22, 24 est déposé sur la totalité de la structure et dans lequel les portions non utilisées sont ensuite retirées, par exemple par photolithographie ou ablation laser. Selon le matériau considéré, le dépôt sur la totalité de la structure peut être réalisé, par exemple, par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie. Selon le procédé de dépôt mis en oeuvre, une étape de séchage des matériaux déposés peut être prévue.

Lorsque la formation des électrodes 22, 24 comprend une étape de dépôt physique en phase vapeur, le procédé comprend le dépôt d'une couche conductrice sur le revêtement 18 ou 20 et la gravure de cette couche pour délimiter les électrodes 22, 24. La gravure peut comprendre une étape de photolithographie. A titre d'exemple, dans le cas où les électrodes 22, 24 sont en or, la gravure peut être une gravure chimique avec de l'iodure de potassium.

Selon un mode de réalisation, le procédé de formation de l'électrode 22 comprend les étapes suivantes :
dépôt d'une couche d'oxyde de graphène sur la totalité de la face 14, par exemple par dépôt à la tournette ; et
exposition de parties de la couche d'oxyde de graphène à un rayonnement UV au travers d'un masque selon la forme souhaitée de l'électrode 22 pour réduire l'oxyde de graphène et le transformer en graphène.

Le procédé peut, en outre, comprendre la formation d'une couche polaire ayant une forte affinité avec l'eau sur chaque électrode 22, 24 selon l'un des procédés de dépôt décrits précédemment.

Les figures 7A à 7D illustrent un mode de réalisation d'un procédé de fabrication du dispositif piézoélectrique 30 ou 40 représenté sur les figures 4 et 5.

Les étapes initiales du procédé comprennent les étapes décrites précédemment en relation avec les figures 6A et 6B.

La figure 7A représente la structure obtenue après avoir formé l'électrode 22 sur le revêtement 18. L'électrode 22 peut être formée comme cela a été décrit précédemment en relation avec la figure 6C.

Dans le cas où l'électrode 22 est en un matériau carboné, le procédé peut comprendre le dépôt d'une composition liquide, éventuellement visqueuse, puis une étape de séchage pour former l'électrode 22. La composition liquide comprend un solvant et un composé à base d'un matériau carboné dissous dans le solvant. Le solvant peut être choisi parmi le groupe comprenant le cyclohéxane, le chloroforme, le tétrahydrofurane, l'acétate d'éthyle et le xylène. La composition peut comprendre de 5 % à 30 %, en poids du composé carboné et de 85 % à 70 %, en poids du solvant. De façon avantageuse, la concentration en poids du solvant est choisie pour ajuster la viscosité de la composition obtenue afin de permettre la mise en oeuvre de techniques d'impression. Le procédé de formation de l'électrode 22 peut correspondre à un procédé dit additif, notamment par jet d'encre, sérigraphie ou revêtement par pulvérisation, ou à un procédé dit soustractif, tel que décrit précédemment. L'étape de séchage de la composition peut comprendre un recuit réalisé à une température comprise entre 100 °C et 130 °C pendant 10 minutes à 60 minutes.

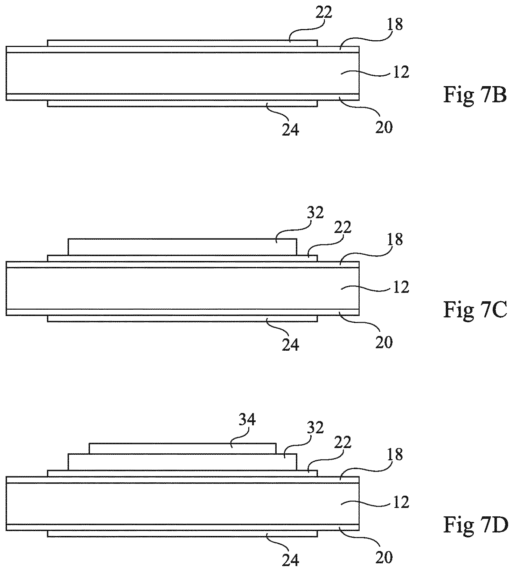

La figure 7B représente la structure obtenue après avoir formé l'électrode 24 sur le revêtement 20. L'électrode 24 peut être formée comme cela a été décrit précédemment en relation avec la figure 6C. Dans le cas où les matériaux composant les électrodes 22 et 24 sont différents, les procédés mis en oeuvre pour la formation de ces couches peuvent être différents.

La figure 7C représente la structure obtenue après avoir formé la couche piézoélectrique 32 sur l'électrode 22. Le procédé peut comprendre le dépôt d'une composition liquide, éventuellement visqueuse comprenant un composé à base de PVDF, puis une étape de cristallisation du composé à base de PVDF pour former la couche piézoélectrique 32.

La composition liquide comprend un solvant et un composé à base de PVDF dissous dans le solvant. De préférence, le solvant est un solvant polaire. Ceci permet, de façon avantageuse, d'améliorer la dissolution du polymère à base de PVDF. De préférence, le solvant est adapté à absorber, au moins partiellement, le rayonnement UV, par exemple sur une plage de longueurs d'onde comprises entre 200 nm et 400 nm. Selon un mode de réalisation, la température d'évaporation du solvant est comprise entre 110 °C et 140 °C, de préférence entre 110 °C et 130 °C, plus préférentiellement entre 120 °C et 130 °C. Le solvant peut être choisi parmi le groupe comprenant le cyclopentanone, le dyméthylsulphoxide (DMSO), le dyméthylformamide (DMF), le dyméthylacétamide (DMAc) ou le N-méthyl-E-pyrrolidone (NMP). De préférence, le solvant est le cyclopentanone.

La composition peut comprendre de 1 % à 30 %, de préférence de 1 % à 30 %, de préférence de 10 % à 25 %, notamment environ 20 %, en poids du composé à base de PVDF et de 70 % à 99 %, de préférence de 75 % à 90 %, notamment environ 80 %, en poids du solvant. De façon avantageuse, la concentration en poids du solvant est choisie pour ajuster la viscosité de la composition obtenue afin de permettre la mise en oeuvre de techniques d'impression. Le procédé de formation de la couche piézoélectrique 32 peut correspondre à un procédé dit additif tel que décrit précédemment, notamment par jet d'encre, sérigraphie ou revêtement par pulvérisation. Le procédé de formation de la couche piézoélectrique 32 peut, en outre, correspondre à un procédé dit soustractif tel que décrit précédemment. Lorsque le procédé de dépôt comprend une étape de sérigraphie, la viscosité de la composition peut varier de 5 Pa.s à 30 Pa.s.

L'étape de cristallisation du composé à base de PVDF peut comprendre un recuit réalisé à une température comprise entre 100 °C et 130 °C pendant 10 minutes à 30 minutes. Selon un autre mode de réalisation, l'étape de cristallisation peut comprendre l'irradiation de la composition aux rayons UV par une succession d'impulsions de rayonnement UV, ou flashs ultraviolets. Selon un mode de réalisation, la durée d'une impulsion UV est comprise entre 500 µs et 2 ms. La durée entre deux impulsions UV successives peut être comprise entre 1 et 5 secondes. La fluence en énergie du rayonnement UV peut être comprise entre 10 J/cm² et 25 J/cm². Le nombre d'impulsions UV dépend notamment de l'épaisseur de la couche piézoélectrique 32. A titre d'exemple, pour une épaisseur de la couche piézoélectrique 32 de 100 nm, le nombre d'impulsions UV peut être de l'ordre de 1 à 2 avec une fluence en énergie entre 10 J/cm² et 15 J/cm² et pour une épaisseur de la couche piézoélectrique 32 de l'ordre de 4 µm, le nombre d'impulsions UV peut être de l'ordre de 2 à 6 avec une fluence en énergie entre 17 J/cm² et 21 J/cm².

De façon avantageuse, pendant l'irradiation de la composition, l'électrode 22 réfléchit une partie du rayonnement UV ayant traversé la composition. Ceci permet d'améliorer la quantité de rayonnement UV reçue par la composition. De façon avantageuse, le solvant de la composition absorbe au moins en partie le rayonnement UV. Ceci permet d'améliorer le chauffage du composé à base d'UV et de favoriser la formation de la phase cristalline β, qui est la phase pouvant présenter des propriétés piézoélectriques. La température d'évaporation du solvant est avantageusement supérieure à 110 °C pour éviter une évaporation trop rapide du solvant avant la formation de la phase cristalline β qui se produit entre 120 °C et 130 °C. De préférence, l'étape d'irradiation entraîne une évaporation de plus de 50 % en poids, de préférence de plus de 80 % en poids, du solvant de la composition.

La figure 7D représente la structure obtenue après avoir formé l'électrode 34 sur la couche piézoélectrique 32. L'électrode 34 peut être formée comme cela a été décrit précédemment en relation avec la figure 6C.

Selon un mode de réalisation, l'électrode 34 peut être formée à partir d'une solution de nanofils d'argent, par exemple la solution commercialisée par la société Henkel sous l'appellation ECI 5003. Le dépôt de la solution de nanofils d'argent peut être suivi d'un recuit, par exemple à une température comprise entre 90 °C et 120 °C. De façon avantageuse, la température de recuit de l'électrode 34 n'entraîne pas de dégradation de la couche piézoélectrique 32. Il peut être avantageux de former l'électrode 34 à partir d'une encre à nanotubes d'argent plutôt qu'une encre comprenant des nanoparticules d'argent, c'est-à-dire des particules d'argent dont le diamètre moyen est compris entre 1 nm et 5 nm. On appelle diamètre moyen d'une nanoparticule le diamètre de la sphère de même volume que la nanoparticule. En effet, l'étape de recuit de la couche de l'encre à nanoparticules doit être mise en oeuvre à une température supérieure à 180 °C, c'est-à-dire à une température entraînant une dégradation de la couche piézoélectrique 32. Il peut être avantageux de former l'électrode 34 à partir d'une encre à nanotubes d'argent plutôt qu'une encre comprenant des paillettes d'argent, c'est-à-dire des particules d'argent dont le diamètre moyen est compris entre 2 µm et 4 µm. En effet, les inventeurs ont mis en évidence que l'électrode 34 obtenue à partir d'une encre comprenant des paillettes d'argent tend à se fissurer, notamment lorsque le film de papier 12 est déformé.

Pour certaines applications, afin d'améliorer les caractéristiques piézoélectriques de la couche piézoélectrique 32 à base de PVDF, un champ électrique continu peut être appliqué à la couche piézoélectrique ayant une intensité qui varie entre 20 V/µm et 80 V/µm pendant plusieurs minutes à 25 °C ou à une température plus élevée, par exemple entre 60 °C et 100 °C. Selon un autre mode de réalisation, les caractéristiques piézoélectriques de la couche 32 à base de PVDF peuvent être améliorées en appliquant un traitement Corona à la couche piézoélectrique 32.

Le dispositif piézoélectrique 30 représenté en figure 4 est obtenu à l'issue des étapes décrites précédemment en relation avec les figures 7A à 7D. Pour obtenir le dispositif piézoélectrique 40 représenté en figure 5, le procédé de fabrication comprend, en outre, une étape de mise en forme du film de papier 12. Selon un mode de réalisation, l'étape de mise en forme comprend le poinçonnage du film de papier 12.

Des modes de réalisation particuliers ont été décrits. Diverses variantes et modifications apparaîtront à l'homme de l'art. En particulier, bien que dans les modes de réalisation décrits précédemment, le dispositif piézoélectrique 30 et 40 comprend une seule couche piézoélectrique à base de PVDF sur une face du film de papier 12, il est clair que le dispositif piézoélectrique peut comprendre une couche piézoélectrique à base de PVDF sur chaque face du film de papier 12.

## Revendications

1. Dispositif piézoélectrique (10 ; 30 ; 40) comprenant :
un film de papier (12) comprenant des fibres de cellulose et contenant un additif, choisi parmi le groupe comprenant le 4-fluorophénéthyl isocyanate, le 2-2 diphényléthyl isocyanate, le nitrophényl isocyanate, le 1-adamantyl isocyanate, le cyanophényl isocyanate et le triphénylamine, greffé aux fibres de cellulose, le film ayant, en outre, une première face (14), et une deuxième face (16) opposée à la première face ; et
une première électrode (22) disposée sur la première face et une deuxième électrode (24) disposée sur la deuxième face.

2. Dispositif piézoélectrique selon la revendication 1, comprenant, en outre :
une couche piézoélectrique (32) s'étendant sur la première électrode (22) ; et
une troisième électrode (34), la couche piézoélectrique (32) étant interposée entre la première électrode (22) et la troisième électrode.

3. Dispositif piézoélectrique selon la revendication 2, dans lequel la couche piézoélectrique (32) comprend du polyfluorure de vinylidène et/ou au moins un copolymère du polyfluorure de vinylidène, notamment un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

4. Dispositif piézoélectrique selon l'une quelconque des revendications 1 à 3, comprenant, en outre, un premier revêtement (18) entre la première face (14) et la première électrode (22) et un deuxième revêtement (20) entre la deuxième face (16) et la deuxième électrode (24).

5. Dispositif piézoélectrique selon la revendication 4, dans lequel le premier revêtement (22) et/ou le deuxième revêtement (24) comprennent un matériau choisi parmi le groupe comprenant le 3-aminopropyl triméthyloxysilane, les polyimides et le poly(N-isopropylacrylamide).

6. Dispositif piézoélectrique selon l'une quelconque des revendications 1 à 5, dans lequel la première électrode (22) et/ou la deuxième électrode (24) comprennent des ouvertures (26) traversantes.

7. Procédé de fabrication d'un dispositif piézoélectrique (10 ; 30 ; 40) comprenant les étapes suivantes :
a) prévoir un film de papier (12) comprenant des fibres de cellulose et ayant une première face (14) et une deuxième face (16), opposée à la première face ;
b) tremper le film de papier (12) dans une solution comportant au moins un additif choisi parmi le groupe comprenant le 4-fluorophénéthyl isocyanate, le 2-2 diphényléthyl isocyanate, le nitrophényl isocyanate, le 1-adamantyl isocyanate, le cyanophényl isocyanate et le triphénylamine ;
c) greffer l'additif aux fibres de cellulose ; et
d) former une première électrode (22) sur la première face et une deuxième électrode (24) sur la deuxième face.

8. Procédé selon la revendication 7, dans lequel l'étape c) comprend l'exposition du film de papier (12) à des impulsions d'un rayonnement ultraviolet.

9. Procédé selon la revendication 8, dans lequel les impulsions ont une durée comprise entre 0,5 et 2 ms et une fluence en énergie comprise entre 5 et 20 J/cm².

10. Procédé selon l'une quelconque des revendications 7 à 9, comprenant, en outre, les étapes suivantes :
e) former une couche comprenant un solvant et du polyfluorure de vinylidène et/ou au moins un copolymère du polyfluorure de vinylidène, notamment un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères ; et
f) exposer la couche à des impulsions d'un rayonnement ultraviolet.

## Patentansprüche

1. Piezoelektrische Vorrichtung (10; 30; 40), welche Folgendes aufweist:
eine Papierfolie (12), die Zellulosefasern aufweist und ein Additiv enthält, das aus der Gruppe ausgewählt ist, die aus Folgendem besteht:
4-fluorphenethylisocyanat, 2-2 diphenylethylisocyanat, Nitrophenylisocyanat, 1-Adamantylisocyanat, Cyanophenylisocyanat und Triphenylamin, gepfropft auf die Cellulosefasern, wobei die Folie ferner eine erste Oberfläche (14) und eine zweite Oberfläche (16) gegenüberliegend zu der ersten Oberfläche hat; und
eine erste Elektrode (22), die auf der ersten Oberfläche angeordnet ist, und eine zweite Elektrode (24), die auf der zweiten Oberfläche angeordnet ist.

2. Piezoelektrische Vorrichtung nach Anspruch 1, die ferner Folgendes aufweist:
eine piezoelektrische Schicht (32), die sich über die erste Elektrode (22) erstreckt; und
eine dritte Elektrode (34), wobei die piezoelektrische Schicht (32) zwischen der ersten Elektrode (22) und der dritten Elektrode angeordnet ist.

3. Piezoelektrische Vorrichtung nach Anspruch 2, wobei die piezoelektrische Schicht (32) Polyvinylidenfluorid und/oder mindestens ein Copolymer von Polyvinylidenfluorid aufweist, insbesondere ein Polymer ausgewählt aus der Gruppe, die aus Folgendem besteht: Polyvinylidenfluorid, Polyvinylidenfluorid - Trifluorethylen), Poly(vinylidenfluorid - Tetrafluorethylen) und eine Mischung aus mindestens zwei dieser Polymere.

4. Piezoelektrische Vorrichtung nach einem der Ansprüche 1 bis 3, die ferner eine erste Beschichtung (18) zwischen der ersten Oberfläche (14) und der ersten Elektrode (22) und eine zweite Beschichtung (20) zwischen der zweiten Oberfläche (16) und der zweiten Elektrode (24) aufweist.

5. Piezoelektrische Vorrichtung nach Anspruch 4, wobei die erste Beschichtung (22) und/oder die zweite Beschichtung (24) ein Material aufweist, das aus der Gruppe ausgewählt ist, die aus Folgendem besteht: 3-Aminopropyl trimethyloxysilan, Polyimide und Poly(N-isopropylacrylamid).

6. Piezoelektrische Vorrichtung nach einem der Ansprüche 1 bis 5, wobei die erste Elektrode (22) und/oder die zweite Elektrode (24) Durchgangsöffnungen (26) aufweisen.

7. Verfahren zur Herstellung einer piezoelektrischen Vorrichtung (10; 30; 40), welches folgende Schritte aufweist:
a) Vorsehen einer Papierfolie (12), welche Cellulosefasern aufweist und eine erste Oberfläche (14) und eine zweite Oberfläche (16), gegenüber der ersten Oberfläche hat;
b) Eintauchen der Papierfolie (12) in eine Lösung, die zumindest ein Additiv aufweist, das aus der Gruppe ausgewählt ist, welche aus Folgendem besteht: 4-fluorphenethylisocyanat, 2-2 diphenylethylisocyanat, Nitrophenylisocyanat, 1-Adamantylisocyanat, Cyanophenylisocyanat und Triphenylamin;
c) Aufpfropfen des Additivs auf die Zellulosefasern; und
d) Formen einer ersten Elektrode (22) auf der ersten Oberfläche und einer zweiten Elektrode (24) auf der zweiten Oberfläche.

8. Verfahren nach Anspruch 7, wobei Schritt c) aufweist, den Papierfilm (12), Impulsen von ultravioletter Strahlung auszusetzen.

9. Verfahren nach Anspruch 8, wobei die Impulse eine Dauer im Bereich von 0,5 bis 2 ms und eine Fluenz von Energie im Bereich von 5 bis 20 J/cm² haben.

10. Verfahren nach einem der Ansprüche 7 bis 9, das ferner die folgenden Schritte aufweist:
e) Formen einer Schicht, welche ein Lösungsmittel und Polyvinylidenfluorid und/oder mindestens ein Copolymer von Polyvinylidenfluorid aufweist, insbesondere ein Polymer, das aus der Gruppe ausgewählt ist, die aus Folgendem besteht: Polyvinylidenfluorid, Poly(vinylidenfluorid - Trifluorethylen), Poly(vinylidenfluorid - Tetrafluorethylen) und eine Mischung aus mindestens zwei dieser Polymere; und
f) Aussetzen der Schicht gegenüber Impulsen von ultravioletter Strahlung.

## Claims

1. A piezoelectric device (10; 30; 40) comprising:
a paper film (12) comprising cellulose fibers and containing an additive selected from the group comprising 4-fluorophenethyl isocyanate, 2-2 diphenylethyl isocyanate, nitrophenyl isocyanate, 1-adamantyl isocyanate, cyanophenyl isocyanate, and triphenylamine grafted to the cellulose fibers, the film further having a first surface (14) and a second surface (16) opposite to the first surface; and
a first electrode (22) arranged on the first surface and a second electrode (24) arranged on the second surface.

2. The piezoelectric device of claim 1, further comprising:
a piezoelectric layer (32) extending on the first electrode (22); and
a third electrode (34), the piezoelectric layer (32) being interposed between the first electrode (22) and the third electrode.

3. The piezoelectric device of claim 2, wherein the piezoelectric layer (32) comprises polyvinylidene fluoride and/or at least one copolymer of polyvinylidene fluoride, particularly a polymer selected from the group comprising polyvinylidene fluoride, poly(vinylidene fluoride - tri fluoro ethylene), poly(vinylidene fluoride - tetra fluoro ethylene), and a mixture of at least two of these polymers.

4. The piezoelectric device of any of claims 1 to 3, further comprising a first coating (18) between the first surface (14) and the first electrode (22) and a second coating (20) between the second surface (16) and the second electrode (24).

5. The piezoelectric device of claim 4, wherein the first coating (22) and/or the second coating (24) comprise a material selected from the group comprising 3-aminopropyl trimethyloxysilane, polyimides, and poly(N-isopropylacrylamide).

6. The piezoelectric device of any of claims 1 to 5, wherein the first electrode (22) and/or the second electrode (24) comprise through openings (26).

7. A method of manufacturing a piezoelectric device (10; 30; 40), comprising the steps of:
a) providing a paper film (12) comprising cellulose fibers and having a first surface (14) and a second surface (16), opposite to the first surface;
b) dipping the paper film (12) into a solution comprising at least one additive selected from the group comprising 4-fluorophenethyl isocyanate, 2-2 diphenylethyl isocyanate, nitrophenyl isocyanate, 1-adamantyl isocyanate, cyanophenyl isocyanate, and triphenylamine;
c) grafting the additive to the cellulose fibers; and
d) forming a first electrode (22) on the first surface and a second electrode (24) on the second surface.

8. The method of claim 7, wherein step c) comprises exposing the paper film (12) to pulses of an ultraviolet radiation.

9. The method of claim 8, wherein the pulses have a duration in the range from 0.5 to 2 ms and an energy fluence in the range from 5 to 20 J/cm².

10. The method of any of claims 7 to 9, further comprising the steps of:
e) forming a layer comprising a solvent and polyvinylidene fluoride and/or at least one copolymer of polyvinylidene fluoride, particularly a polymer selected from the group comprising polyvinylidene fluoride, poly(vinylidene fluoride - tri fluoro ethylene), poly(vinylidene fluoride - tetra fluoro ethylene), and a mixture of at least two of these polymers; and
f) exposing the layer to pulses of an ultraviolet radiation.
